# DEMANDE DE BREVET EUROPEEN

(11) **EP 4 084 085 A1**
(43) Date de publication de la demande: **02.11.2022**
(21) Numéro de dépôt: 22170118.8
(22) Date de dépôt: 26.04.2022
(51) Int. Cl.: H01L 29/778, H01L 29/20, H01L 29/423, H01L 29/417

(54) **DISPOSITIF MICROÉLECTRONIQUE**

(30) Priorité: 30.04.2021 FR 2104559
(71) Demandeur: Commissariat à l'énergie atomique et aux énergies alternatives, 75015 Paris (FR)
(72) Inventeur: BUCKLEY, Julien, 38054 GRENOBLE Cedex 09 (FR); MOHAMAD, Blend, 38054 GRENOBLE Cedex 09 (FR)
(74) Mandataire: Hautier IP - MC/EP

(57) **Abrégé**

L'invention porte sur un transistor de puissance à base de GaN comprenant :
- un empilement (1) de couches (10, 11, 12, 13, 14) selon une direction verticale (z), ledit empilement (1) comprenant, à partir d'une surface supérieure (100) dudit empilement :
∘ Une première barrière (11) à base d'AIGaN,
∘ Une couche (10) à base de GaN,
∘ Une deuxième barrière (12) à base d'AIGaN,

- un motif de grille (20) comprenant :
∘ Une grille métallique (21)
∘ Un diélectrique de grille (22) isolant électriquement la grille métallique (21) de l'empilement (1),

Ledit motif de grille (20) traversant la première barrière (11) à base d'AIGaN.

Avantageusement, le motif de grille (20) du transistor traverse totalement la couche (10) à base de GaN et au moins en partie la deuxième barrière (12) à base d'AIGaN, selon la direction verticale (z).

## Description

### DOMAINE TECHNIQUE

La présente invention concerne le domaine de la microélectronique. Elle trouve pour application particulièrement avantageuse la réalisation de transistors de puissance à base de GaN. Un exemple d'application particulier concerne les transistors GaN à gaz bidimensionnel d'électrons (2DEG).

### ETAT DE LA TECHNIQUE

Dans le domaine de l'électronique de puissance, un enjeu important concerne le développement de transistors de puissance à base de semiconducteurs « grand gap » tels que le GaN.

Différentes architectures ont été spécifiquement développées pour ces transistors à base de GaN. Les architectures basées sur l'utilisation d'un gaz bidimensionnel d'électrons (2DEG) permettent typiquement de fonctionner avec des tensions de polarisation source-drain élevées. Une tension de seuil positive permet avantageusement de simplifier le circuit de commande du transistor et d'assurer la sécurité du système de conversion en cas de défaillance.

Le document « Miyamoto et al., Jpn. J. Appl. Phys. 59 044002, 2020 » divulgue un transistor GaN 2DEG à tension de seuil positive. Ce transistor comprend un empilement de couches selon une direction verticale (z) comprenant, à partir d'une surface supérieure dudit empilement :
- Une première barrière à base d'AlGaN,
- Un canal à base de GaN,
- Une deuxième barrière à base d'AlGaN.

Ce transistor comprend en outre un motif de grille comprenant :
- Une grille métallique
- Un diélectrique de grille séparant la grille métallique des couches dudit empilement.

Le canal à base de GaN est compris entre les première et deuxième barrières à base d'AlGaN, et le motif de grille de ce transistor traverse la première barrière à base d'AlGaN et débouche par son extrémité inférieure au sein du canal à base de GaN. Dans cette architecture, le gaz bidimensionnel d'électrons se forme par effet de polarisation piézoélectrique et spontanée sous la première barrière à base d'AlGaN, de part et d'autre du motif de grille. L'application d'une tension source-grille Vgs supérieure à la tension de seuil Vth permet aux électrons de circuler dans le canal. La tension de seuil est ici rendue positive par la présence de la deuxième barrière à base d'AlGaN, par un simple effet électrostatique.

Un inconvénient de cette solution est que la valeur de la tension de seuil est relativement faible (<1V) ce qui peut nécessiter de commander le transistor en blocage avec une valeur Vgs<0. L'application d'une tension Vgs<0 implique de recourir à un circuit de commande plus complexe. Par ailleurs, il s'avère que, avec cette solution, la résistance du transistor à l'état passant augmente. Cela dégrade le courant électrique Iₒₙ à l'état passant.

On connait en outre de la publication brevet JP 2008010803 A1 une architecture de transistor III-V à tension de seuil positive. Elle présente un fonctionnement très spécifique du fait de la structure du motif de grille dans laquelle la paroi latérale de la grille métallique n'est pas au contact du diélectrique de grille.

On connaît par ailleurs des documents brevet US 20110068371 A1 et US 20140264273 A1 des architectures de transistors de puissance basées sur un gaz bidimensionnel d'électrons dans lesquelles le motif de grille traverse une pluralité d'alternances de couches de AIGaN et de couches de GaN. Dans leur fonctionnement, les transistors de ces deux publications brevet visent à diminuer la résistance sur un chemin de conduction horizontal et la deuxième barrière doit fournir des porteurs de charge. Le contrôle du courant électrique Iₒₙ à l'état passant est rendu plus complexe.

Il existe donc un besoin consistant à proposer une architecture de transistor de puissance GaN 2DEG surmontant les inconvénients mentionnés ci-dessus.

Un objet de la présente invention est de proposer un transistor de puissance à base de GaN présentant une tension de seuil Vth positive et suffisamment élevée, typiquement Vth > 1V et de préférence Vth > 2V.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un transistor de puissance à base de GaN comprenant un empilement de couches selon une direction verticale (z), ledit empilement comprenant, à partir d'une surface supérieure dudit empilement :
- Une première barrière à base d'AlGaN,
- Une couche à base de GaN,
- Une deuxième barrière à base d'AlGaN.

Ce transistor comprend en outre un motif de grille comprenant :
- Une grille métallique
- Un diélectrique de grille isolant électriquement la grille métallique de l'empilement.

Le motif de grille du transistor traverse la première barrière à base d'AlGaN.

Avantageusement, le motif de grille du transistor traverse totalement la couche à base de GaN et au moins en partie la deuxième barrière à base d'AlGaN. L'extrémité inférieure du motif de grille débouche dans ladite deuxième barrière à base d'AlGaN, ou sous ladite deuxième barrière à base d'AlGaN, par exemple dans une deuxième couche à base de GaN formant un canal de conduction. Il existe ainsi une intersection entre le motif de grille et la deuxième barrière à base d'AlGaN.

La tension de polarisation Vgs nécessaire au passage des électrons autour du motif de grille est ainsi augmentée. La tension de seuil Vth au-delà de laquelle le transistor se trouve à l'état passant est significativement augmentée.

Cette augmentation de Vth est induite au premier ordre par la barrière physique formée par la deuxième barrière à base d'AlGaN pour le passage des électrons. La tension de seuil n'est plus seulement modulée par effet de répulsion électrostatique comme c'est le cas dans le transistor divulgué par la solution de l'art antérieur. Au contraire, la tension de seuil est ici augmentée d'une barrière de potentiel supplémentaire à franchir.

La tension de seuil bénéficie également au deuxième ordre de l'effet de répulsion électrostatique induit à proximité de la deuxième barrière à base d'AlGaN.

Un effet synergique est ainsi obtenu entre le premier effet, prépondérant, lié au franchissement de la deuxième barrière elle-même, et le deuxième effet, mineur, lié à la répulsion électrostatique environnant ladite deuxième barrière.

Le principe d'augmentation de Vth sur lequel se base la présente invention est ainsi fondamentalement différent du principe sur lequel se base la solution de l'art antérieur.

Le transistor selon la présente invention présente ainsi une tension de seuil Vth significativement plus élevée que celle du transistor selon l'art antérieur.

Par ailleurs, au cours du développement de la présente invention, il est apparu que l'augmentation de résistance à l'état passant observée en mettant en œuvre la solution de l'art antérieur était due à la proximité de la deuxième barrière à base d'AlGaN vis-à-vis de la première barrière à base d'AlGaN. Le gaz bidimensionnel d'électrons formé sous la première barrière à base d'AlGaN est en effet déplété par le champ électrostatique régnant autour de la deuxième barrière. Ainsi, plus la deuxième barrière est proche de la première barrière, plus le gaz bidimensionnel d'électrons est déplété, et plus la résistance à l'état passant augmente.

Selon la présente invention, le motif de grille est prolongé en profondeur au moins jusqu'à la deuxième barrière. Cela permet avantageusement d'éloigner la deuxième barrière de la première barrière, de façon à limiter voire éliminer la déplétion du gaz bidimensionnel d'électrons formé sous la première barrière à base d'AlGaN. Selon un exemple, la deuxième barrière à base d'AlGaN est séparée de la première barrière à base d'AlGaN par une couche de GaN d'épaisseur supérieure ou égale à 50 nm, de préférence supérieure ou égale à 100 nm. Cela permet de limiter significativement l'augmentation de résistance à l'état passant du transistor. De préférence, on utilise une concentration d'aluminium inférieure ou égal à 8 %at pour la deuxième barrière. Dans cette configuration, la deuxième barrière joue un rôle particulier en ce qu'elle forme une barrière de potentiel traversée par des porteurs de charge ; une concentration trop élevée en aluminium ne permettrait pas de traverser cette barrière de potentiel verticalement le long du flanc du motif de grille. En ce sens, le fonctionnement obtenu par le transistor de puissance selon la présente invention est inverse à celui recherché dans les publications US 20110068371 A1 et US 20140264273 A1.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre schématiquement un transistor selon un premier mode de réalisation de la présente invention.
La figure 2 illustre schématiquement un transistor selon un deuxième mode de réalisation de la présente invention.
La figure 3 illustre schématiquement un transistor selon un troisième mode de réalisation de la présente invention.
La figure 4 illustre schématiquement un transistor selon un quatrième mode de réalisation de la présente invention.
La figure 5 présente une courbe d'évolution de la tension de seuil Vth de la grille du transistor en fonction de la concentration d'aluminium [Al]2 dans la deuxième barrière à base d'AlGaN.
La figure 6 présente une courbe d'évolution de la tension de seuil Vth de la grille du transistor en fonction de l'épaisseur e12 de la deuxième barrière à base d'AlGaN.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches, et les dimensions des différents motifs (grille, source, drain etc) ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la couche à base de GaN et la deuxième barrière à base d'AlGaN sont au contact l'une de l'autre au niveau d'un plan d'interface, et le motif de grille forme une intersection avec ledit plan d'interface. L'intersection entre le motif de grille et le plan d'interface s'entend en particulier au sens mécanique. Selon un exemple, seul le diélectrique de grille forme une intersection avec le plan d'interface. Selon un exemple, le diélectrique de grille et la grille métallique forment chacun une intersection avec ledit plan d'interface.
Selon un exemple, le motif de grille traverse totalement selon la direction verticale z la deuxième barrière à base d'AlGaN.
Selon un exemple, la grille métallique du motif de grille présente une extrémité au niveau d'un plan basal parallèle au plan d'interface et passant au sein de la deuxième barrière à base d'AlGaN.
Selon un exemple, la grille métallique du motif de grille présente une extrémité au niveau d'un plan basal parallèle au plan d'interface et passant au sein de la couche à base de GaN.
Selon un exemple, la grille métallique du motif de grille présente une extrémité située à une profondeur d210 et la deuxième barrière à base d'AlGaN présente une surface située à une profondeur d12, telles que d210 < d12, lesdites profondeurs d210 et d12 étant prises selon la direction verticale à partir d'un plan de référence passant par la surface supérieure de l'empilement.
Selon un exemple, la grille métallique du motif de grille présente une extrémité située à une profondeur d210 et la deuxième barrière à base d'AlGaN présente une surface située à une profondeur d12, telles que d210 > d12, lesdites profondeurs d210 et d12 étant prises selon la direction verticale à partir d'un plan de référence passant par la surface supérieure de l'empilement.
Selon un exemple, la grille métallique du motif de grille présente une extrémité située à une profondeur d210 et la couche à base de GaN présente une surface située à une profondeur d10, telles que d210 < d10, lesdites profondeurs d210 et d10 étant prises selon la direction verticale à partir d'un plan de référence passant par la surface supérieure de l'empilement.
Selon un exemple, la grille métallique du motif de grille présente une extrémité située à une profondeur d210 et la couche à base de GaN présente une surface située à une profondeur d10, telles que d210 > d10, lesdites profondeurs d210 et d10 étant prises selon la direction verticale à partir d'un plan de référence passant par la surface supérieure de l'empilement.
Selon un exemple, le motif de grille présente une extrémité située à une profondeur d20 et la deuxième barrière à base d'AlGaN présente une surface située à une profondeur d12, telles que d20 < d12, lesdites profondeurs d20 et d12 étant prises selon la direction verticale à partir d'un plan de référence passant par la surface supérieure de l'empilement.
Selon un exemple, le motif de grille présente une extrémité située à une profondeur d20 et la deuxième barrière à base d'AlGaN présente une surface située à une profondeur d12, telles que d20 > d12, lesdites profondeurs d20 et d12 étant prises selon la direction verticale à partir d'un plan de référence passant par la surface supérieure de l'empilement.
Selon un exemple, la deuxième barrière à base d'AlGaN présente une concentration en aluminium [Al]2 inférieure ou égale à 8%at, et de préférence comprise entre 2%at et 8%at. Suivant une possibilité, cette concentration est constante au sein de la deuxième barrière ; en particulier, elle ne varie pas suivant l'épaisseur de cette dernière, ni transversalement à l'épaisseur.
Selon un exemple, la concentration en aluminium [Al]2 présente un profil gaussien selon la direction verticale. Cela permet de rendre la deuxième barrière moins abrupte pour le passage du gaz bidimensionnel d'électrons. Le courant du transistor à l'état passant Iₒₙ est ainsi moins dégradé.
Selon un exemple, la deuxième barrière à base d'AlGaN présente un gradient de concentration en aluminium [Al]2(z) selon la direction verticale. En particulier, en dehors du profil gaussien, il peut y avoir une variation monotone de la concentration [Al]2 selon la direction verticale ; la concentration minimale peut être située à l'interface entre la couche à base de GaN et la deuxième barrière à base d'AlGaN.
Selon un exemple, la deuxième barrière à base d'AlGaN présente une épaisseur e12 prise selon la direction verticale comprise entre 20nm et 50nm.
Selon un exemple, la deuxième barrière à base d'AlGaN comprend une pluralité de couches arrangées en super-réseau. Ladite pluralité de couche peut former des puits quantiques.
Selon un exemple, le transistor comprend en outre une source et un drain de part et d'autre du motif de grille, ladite source traversant totalement selon la direction verticale la deuxième barrière à base d'AlGaN.

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

Dans le cadre de la présente invention, les architectures de transistors de puissance envisagées sont typiquement à conduction latérale, entre une source et un drain, et plus particulièrement basées sur un principe de conduction par gaz bidimensionnel d'électrons (2DEG).

Une telle architecture de transistor inclut la superposition de deux couches semi-conductrices ayant des bandes interdites différentes qui forment un puit quantique à leur interface. Ce puit quantique est induit par les charges de polarisation spontanée et piézoélectrique en présence. Des électrons sont confinés dans ce puits quantique pour former un gaz bidimensionnel d'électrons.

Les transistors de type HEMT (acronyme de « High Electron Mobility transistor », qui signifie transistor à effet de champ à haute mobilité d'électrons), parfois également désignés par le terme de transistor à effet de champ à hétérostructure, sont des exemples de transistors basés sur cette architecture à gaz bidimensionnel d'électrons.

Pour des raisons de tenue en puissance (en particulier haute tension) et en température, le matériau semi-conducteur de ces transistors est choisi de façon à présenter une large bande d'énergie interdite. Parmi les transistors HEMT à large bande d'énergie interdite, les transistors à base de nitrure de gallium sont très prometteurs.

Avec un transistor à conduction latérale, la tension de claquage grille/drain peut aisément être contrôlée par une distance appropriée entre grille et drain. Une tension de claquage de l'ordre de 600 V peut ainsi être atteinte pour une distance entre la grille et le drain du transistor de l'ordre de quelques microns (6 à 15 µm par exemple). De plus, de tels transistors permettent de très grandes densités de courant du fait de la très grande mobilité électronique et de la forte densité électronique dans le gaz d'électrons d'interface.

Dans le cadre de la présente invention, le passage du courant est typiquement piloté par une grille polarisée positivement par rapport à la source.

Cette grille peut être de type MOS ou MOSFET (acronyme anglais de « Metal Oxide Semiconductor Field Effect Transistor »). Dans ce cas, la grille métallique est isolée électriquement des couches semi-conductrices par un diélectrique de grille. D'autres compositions de grille peuvent être envisagées. Une particularité des architectures de transistors selon la présente invention est que la grille traverse le puit quantique au niveau duquel est confiné le gaz bidimensionnel d'électrons. La continuité du gaz bidimensionnel d'électrons est ainsi rompue par une tranchée dans laquelle est réalisée la grille MOS du transistor.

Généralement, si la grille du transistor est mise à une tension supérieure à une tension seuil, il y a accumulation d'électrons sous le diélectrique de grille, connectant ainsi le gaz bidimensionnel d'électrons de part et d'autre de celle-ci ce qui permet de relier la source et le drain de façon à ce que le transistor devienne passant.

Si la grille du transistor est mise à une tension inférieure à la tension seuil, la source et le drain ne sont plus connectés et le transistor est dit bloqué.

Les composants présentant une tension de seuil positive sont dits « à enrichissement » ou en langue anglaise « normally -off ». L'invention s'applique plus particulièrement à des transistors de puissance 2DEG à enrichissement.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Par exemple et de façon connue en soi dans le domaine des transistors de type HEMT à base de GaN, une fine couche en AIN peut être intercalée entre deux couches semi-conductrices en GaN et en AIGaN.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants.

Les gammes de dopage associées aux différents types de dopage indiqués dans la présente demande sont les suivantes :
- dopage p++ ou n++ : supérieur à 1 × 10²⁰cm⁻³
- dopage p+ ou n+ : 1 × 10¹⁸ cm⁻³ à 9 × 10¹⁹ cm⁻³
- dopage p ou n : 1 × 10¹⁷ cm⁻³ à 1 × 10¹⁸ cm⁻³
- dopage intrinsèque ou non intentionnellement dopé : de l'ordre de n.10¹⁵ cm⁻³ ou en-dessous (n étant typiquement compris entre 1 et 9).

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

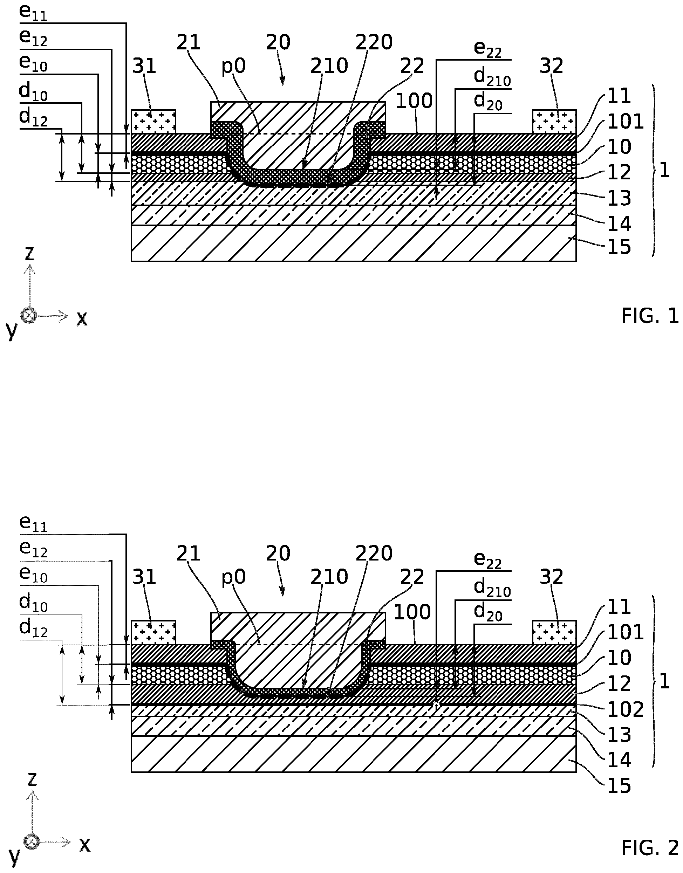

Des exemples de transistors selon la présente invention sont illustrés aux figures 1 à 4. L'architecture générale de ces transistors comprend une source 31 et un drain 32 formés de part et d'autre d'un motif de grille 20. Le motif de grille 20 s'étend en partie au travers d'un empilement 1 de couches 10, 11, 12, 13, 14 formé sur un substrat 15. Des caractéristiques générales de ces transistors, communes à tous les modes de réalisation, sont indiquées ci-dessous. Les caractéristiques spécifiques à chaque mode de réalisation sont détaillées par la suite.

Le substrat 15 peut être un substrat à base de Silicium (111). Alternativement, le substrat 15 peut être à base de saphir ou de SiC. Des substrats connus de GaN sur saphir ou de GaN sur silicium peuvent typiquement être utilisés.

L'empilement 1 peut comprendre une pluralité de couches à base de matériaux III-V épitaxiées sur le substrat 15. L'empilement 1 comprend ainsi typiquement, en partant du substrat 15 et selon la direction z :
- Une ou plusieurs couches 14 dites tampon. Ces couches 14 ont pour objectif d'améliorer la qualité cristalline des couches supérieures. Elles peuvent par exemple accorder les différences de paramètres de maille entre les matériaux III-V utilisés et le substrat, et/ou encaisser la relaxation plastique induite par les différentes sources de contraintes mécaniques, et/ou limiter l'apparition ou la transmission des défauts cristallins.
- Une couche 13 de GaN non intentionnellement dopée.
- La deuxième barrière 12 à base d'AlGaN. La deuxième barrière 12 à base d'AlGaN présente une épaisseur e12 comprise entre 20 nm et 50 nm.
- La couche 10 à base de GaN est non intentionnellement dopée. La couche 10 à base de GaN présente une épaisseur e10, par exemple comprise entre 50 nm et 200 nm.
- La première barrière 11 à base d'AlGaN. La première barrière 11 à base d'AlGaN présente une épaisseur e11, par exemple comprise entre 20 nm et 100 nm.

Les différentes couches épitaxiées, en particulier les première et deuxième barrières 11, 12 et la couche 10 à base de GaN, peuvent être très précisément contrôlées en épaisseur. Une variabilité inférieure à 0,5 nm en épaisseur est typiquement obtenue pour ces couches épitaxiées. Cela permet *in fine* de contrôler précisément les distances séparant les différentes couches et les effets électrostatiques visés.

La deuxième barrière 12 à base d'AlGaN comprend typiquement un taux d'aluminium [Al]2 compris entre 2%at. et 8%at. Un taux [Al]2 inférieur ou égal à 8%at. environ permet de conserver un paramètre de maille compatible avec une épitaxie de GaN de qualité cristalline requise pour le transistor. La couche 10 à base de GaN peut ainsi être épitaxiée sur la deuxième barrière 12 à base d'AlGaN en limitant l'apparition de défauts cristallins. Un taux d'aluminium élevé peut diminuer le courant passant au travers de la deuxième barrière 12. Selon une possibilité, la deuxième barrière 12 à base d'AlGaN présente un gradient de concentration d'aluminium [Al]2(z) selon z. Par exemple, [Al]2(z) présente un profil gaussien centré sur la moitié de l'épaisseur e12 de la deuxième barrière 12. Cela permet de limiter un effet de barrière abrupte. Le courant à l'état passant Iₒₙ est ainsi moins dégradé.

Dans cet empilement 1, un gaz bidimensionnel d'électrons 101 se forme sous la première barrière 11 à base d'AlGaN, dans la couche 10 à base de GaN. Le gaz bidimensionnel d'électrons 101 est typiquement confiné à l'interface entre la première barrière 11 à base d'AlGaN et la couche 10 à base de GaN.

Le motif de grille 20 traverse cette interface entre la première barrière 11 à base d'AlGaN et la couche 10 à base de GaN, de façon à interrompre le gaz bidimensionnel d'électrons 101. Le contrôle de la tension de grille Vgs permet d'autoriser ou de bloquer le passage des électrons du gaz bidimensionnel d'électrons 101 de part et d'autre du motif de grille 20. Le motif de grille 20 comprend une grille métallique 21 et un diélectrique de grille 22 séparant la grille métallique 21 de l'empilement 1. Comme représenté sur les figures 1 à 4, le motif de grille 20 comprend une grille métallique 21 au contact du diélectrique de grille 22. C'est le diélectrique de grille 22 qui réalise l'interface relativement aux couches de l'empilement 1. La grille métallique 21 et le diélectrique de grille 22 présentent une extension en profondeur de sorte à ce que le motif 20 s'étende dans l'épaisseur de l'empilement 1. Dans ce contexte, ces deux éléments ont une forme telle qu'ils présentent une partie de fond (comme révélé par l'extrémité 210 et l'extrémité 220 visibles aux figures 1 à 4 ; la partie de fond peut être dirigée au moins en partie suivant un plan parallèle au plan de référence p0) et une partie de paroi, ou encore des flancs s'étendant au moins en partie, et de préférence au moins majoritairement, suivant un plan perpendiculaire au plan de référence p0. Les parties de fond de la grille 21 et du diélectrique de grille 22 sont au contact l'une de l'autre. Les parties de paroi de la grille 21 et du diélectrique de grille 22 sont au contact l'une de l'autre.

La grille métallique 21 et le diélectrique 22 sont donc en contact sur leur fond et sur leur flanc.

Le motif de grille 20 présente une extrémité inférieure 220, qui correspond à l'extrémité inférieure 220 du diélectrique de grille 22, et cette extrémité inférieure 220 est située à une profondeur d20 selon z par rapport au plan de référence p0. La grille métallique 21 présente une extrémité inférieure 210 située à une profondeur d210 selon z par rapport au plan de référence p0. La surface inférieure de la deuxième barrière 12 est située à une profondeur d12 selon z par rapport au plan de référence p0. La surface inférieure de la couche 10 à base de GaN, qui correspond à la surface supérieure de la deuxième barrière 12, est située à une profondeur d10 selon z par rapport au plan de référence p0.

Le motif de grille 20 traverse totalement la couche 10 à base de GaN, et au moins en partie la deuxième barrière 12 à base d'AlGaN. Ainsi, l'extrémité inférieure 220 est située dans la deuxième barrière 12, ou sous la deuxième barrière 12.

Le motif de grille 20 est typiquement formé par les étapes successives suivantes :
- une tranchée est préalablement formée dans l'empilement 1, par exemple par gravure, puis
- le diélectrique de grille 22 est formé sur les parois et le fond de la tranchée, par exemple par dépôt conforme ou par oxydation, puis
- la tranchée est remplie par un ou plusieurs dépôts métalliques.

Des recuits et/ou des nettoyages peuvent être effectués avant ou après certaines de ces étapes.

La grille métallique 21 peut être à base d'un alliage métallique, par exemple à base d'or et/ou de platine et/ou de titane. Le diélectrique de grille 22 est typiquement à base d'alumine Al2O3. Alternativement, le diélectrique de grille 22 peut être à base de SiN, ou de SiO2, ou de HFO2 par exemple. Le diélectrique de grille 22 présente de préférence une épaisseur e22 environ constante le long des parois et du fond de la tranchée.

Dans le premier mode de réalisation illustré à la figure 1, le motif de grille 20 traverse la deuxième barrière 12 à base d'AlGaN, et débouche dans la couche 13 de GaN non intentionnellement dopée. La deuxième barrière 12 à base d'AlGaN présente par exemple une épaisseur e12 de l'ordre de 30 nm. L'épaisseur e22 du diélectrique de grille 22 est ici plus grande que l'épaisseur e12, de sorte que l'extrémité inférieure 220 est située en-dessous de la deuxième barrière 12, tandis que l'extrémité inférieure 210 de la grille 21 est située au-dessus de la deuxième barrière 12. En particulier, les profondeurs d210, d10, d12 et d20 sont telles que d210<d10<d12<d20. A l'état passant, le gaz bidimensionnel d'électrons 101 traverse la deuxième barrière 12 à base d'AlGaN et s'étend sous l'extrémité inférieure 220, dans la couche 13 de GaN non intentionnellement dopée. La tension de seuil Vth du transistor est significativement augmentée du fait de la deuxième barrière 12 à base d'AlGaN à traverser.

Dans le deuxième mode de réalisation illustré à la figure 2, le motif de grille 20 traverse seulement partiellement la deuxième barrière 12 à base d'AlGaN. La deuxième barrière 12 à base d'AlGaN présente par exemple une épaisseur e12 de l'ordre de 50 nm. L'extrémité inférieure 220 est ainsi située au sein de la deuxième barrière 12 à base d'AlGaN. A l'état passant, le gaz bidimensionnel d'électrons 101 s'étend dans la deuxième barrière 12 à base d'AlGaN. Il interagit avec la deuxième barrière 12 sur une distance plus importante que dans le premier mode de réalisation. Cela peut augmenter encore plus la tension de seuil Vth du transistor. Comme représenté sur la figure 2, un deuxième gaz bidimensionnel d'électrons 102 se forme typiquement sous la deuxième barrière 12 à base d'AlGaN, dans la couche 13 à base de GaN non intentionnellement dopée.

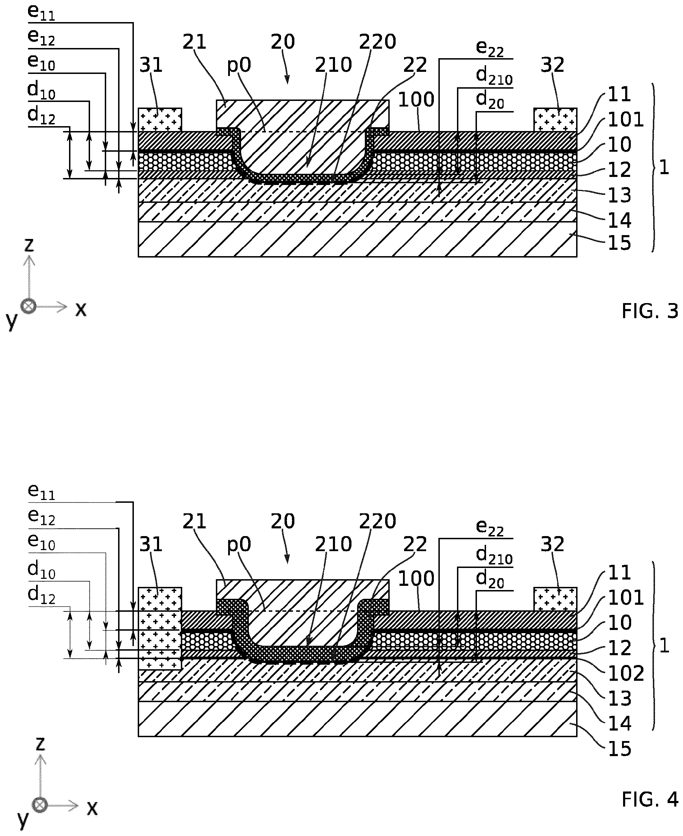

Dans le troisième mode de réalisation illustré à la figure 3, le motif de grille 20 traverse la deuxième barrière 12 à base d'AlGaN, et débouche dans la couche 13 de GaN non intentionnellement dopée. Dans ce mode de réalisation, l'extrémité inférieure 220 est située en-dessous de la deuxième barrière 12, et l'extrémité inférieure 210 de la grille 21 est située en-dessous de la couche 10. En particulier, les profondeurs d210, d10, d12 et d20 sont telles que d10<d210<d12<d20.

Dans le quatrième mode de réalisation illustré à la figure 4, la source 31 du transistor traverse les première et deuxième barrières 11, 12 à base d'AlGaN, et débouche dans la couche 13 de GaN non intentionnellement dopée. La source 31 est ainsi reliée au deuxième gaz bidimensionnel d'électrons 102 sous la deuxième barrière 12 à base d'AlGaN. Cela permet d'améliorer le couplage électrostatique entre la source 31 et la grille 21.

Ces modes de réalisation peuvent éventuellement être combinés entre eux de manière à former un autre mode qui n'est pas nécessairement illustré.

Quel que soit le mode de réalisation envisagé, la tension de seuil Vth est significativement augmentée par l'effet de la deuxième barrière 12, typiquement Vth > 1V, et même Vth> 2V.

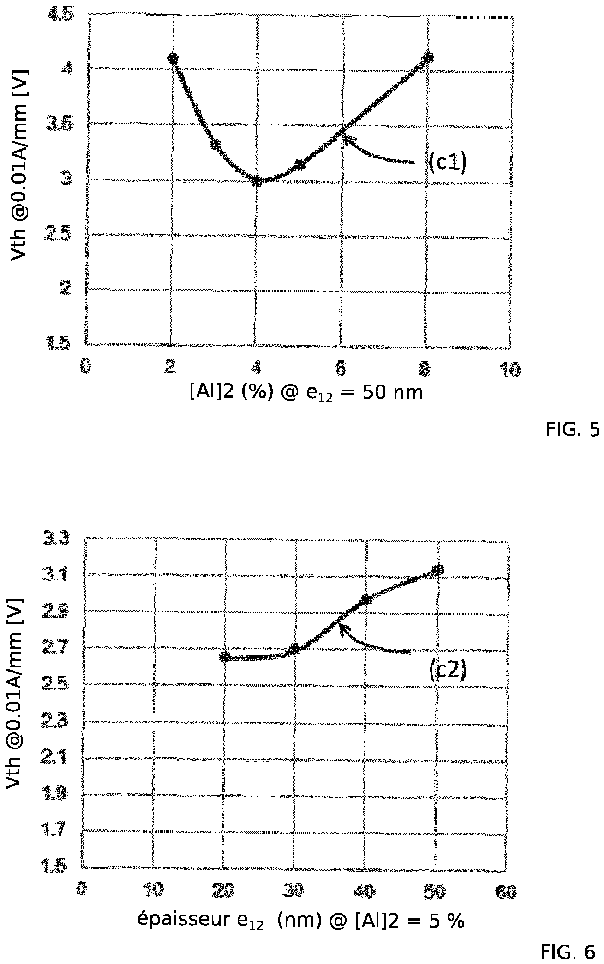

Les figures 5 et 6 présentent l'évolution de la tension de seuil Vth en fonction de la concentration en aluminium [Al]2 et/ou de l'épaisseur e12 de la deuxième barrière 12.

Comme illustré à la figure 5, pour une épaisseur e12 = 50 nm, la tension de seuil Vth est supérieure ou égale à 3V sur toute la gamme de concentration 2%at. ≤ [Al]2 ≤ 8%at. Un taux d'AI à 2% permet d'obtenir une tension de seuil élevée et un niveau de courant élevé. Un taux d'AI à 8% permet également d'obtenir une tension de seuil élevée, mais le niveau de courant est relativement plus faible. Le minimum observé sur la courbe (c1) de Vth autour de 5%at. est due à un minimum local du bas de la bande de conduction dans l'AlGaN.

Comme illustré à la figure 6, pour une concentration [Al]2 = 5%at., la tension de seuil Vth est supérieure ou égale à 2,5V sur toute la gamme d'épaisseur 20nm ≤ e12 ≤ 50nm. La courbe (c2) est monotone. Ainsi, plus l'épaisseur e12 augmente, plus la tension de seuil Vth augmente.

Les transistors 2DEG à enrichissement selon la présente invention peuvent être avantageusement mis en œuvre dans des convertisseurs de puissance, par exemple des convertisseurs DC/AC (courant direct / courant alternatif), DC/DC et AC/DC, ou encore des convertisseurs de type « buck » (abaisseur de tension) ou « boost » (élévateur de tension).

L'invention n'est pas limitée aux modes de réalisations précédemment décrits.

## Revendications

1. Transistor de puissance à base de GaN comprenant :
- un empilement (1) de couches (10, 11, 12, 13, 14) selon une direction verticale (z), ledit empilement (1) comprenant, à partir d'une surface supérieure (100) dudit empilement :
∘ Une première barrière (11) à base d'AlGaN,
∘ Une couche (10) à base de GaN,
∘ Une deuxième barrière (12) à base d'AlGaN,
- un motif de grille (20) comprenant :
∘ Une grille métallique (21)
∘ Un diélectrique de grille (22) isolant électriquement la grille métallique (21) de l'empilement (1), la grille métallique (21) étant au contact d'une partie de fond et d'une partie de paroi du diélectrique de grille (22),
ledit motif de grille (20) traversant la première barrière (11) à base d'AlGaN, puis traversant totalement la couche (10) à base de GaN et au moins en partie la deuxième barrière (12) à base d'AlGaN, selon la direction verticale (z), ledit transistor étant **caractérisé en ce que** la deuxième barrière (12) à base d'AlGaN présente une concentration en aluminium [Al]2 inférieure ou égale à 8%at.

2. Transistor selon la revendication précédente dans lequel le motif de grille (20) du transistor traverse totalement la première barrière (11) à base d'AlGaN, traverse totalement la couche (10) à base de GaN et au moins en partie la deuxième barrière (12) à base d'AlGaN, sans traverser aucune barrière à base d'AlGaN autre que la première barrière (11) à base d'AlGaN et la deuxième barrière (12) à base d'AlGaN.

3. Transistor selon l'une quelconque des revendications précédentes, dans lequel la grille métallique (21) du motif de grille (20) présente une extrémité (210) située à une profondeur d210 et la deuxième barrière (12) à base d'AlGaN présente une surface située à une profondeur d12, telles que d210 est strictement inférieure à d12, lesdites profondeurs d210 et d12 étant prises selon la direction verticale à partir d'un plan de référence (p0) passant par la surface supérieure (100) de l'empilement (1).

4. Transistor selon l'une quelconque des revendications précédentes, dans lequel le motif de grille (20) traverse totalement selon la direction verticale (z) la deuxième barrière (12) à base d'AlGaN.

5. Transistor selon l'une quelconque des revendications précédentes dans lequel la grille métallique (21) du motif de grille (20) présente une extrémité (210) au niveau d'un plan basal (xy) passant au sein de la deuxième barrière (12) à base d'AlGaN.

6. Transistor selon l'une quelconque des revendications 1 à 4 dans lequel la grille métallique (21) du motif de grille (20) présente une extrémité (210) au niveau d'un plan basal (xy) passant au sein de la couche (10) à base de GaN.

7. Transistor selon l'une quelconque des revendications précédentes dans lequel la couche à base de GaN (10) séparant la deuxième barrière (12) à base d'AlGaN de la première barrière (11) à base d'AlGaN, présente une épaisseur e₁₀ supérieure ou égale à 100 nm.

8. Transistor selon l'une quelconque des revendications précédentes dans lequel la deuxième barrière (12) à base d'AlGaN présente une concentration en aluminium [Al]2 comprise entre 2%at et 8%at.

9. Transistor selon l'une quelconque des revendications précédentes dans lequel la deuxième barrière (12) à base d'AlGaN présente un gradient de concentration en aluminium [Al]2(z) selon la direction verticale (z).

10. Transistor selon la revendication précédente dans lequel la concentration en aluminium [Al]2(z) présente un profil gaussien selon la direction verticale (z), ledit profil étant centré sur la moitié de l'épaisseur e12 de la deuxième barrière (12).

11. Transistor selon l'une quelconque des revendications 1 à 8, dans lequel la deuxième barrière (12) à base d'AlGaN présente une concentration en aluminium [Al]2 qui est constante.

12. Transistor selon l'une quelconque des revendications précédentes dans lequel la deuxième barrière (12) à base d'AlGaN présente une épaisseur e12 prise selon la direction verticale (z) comprise entre 20nm et 50nm.

13. Transistor selon l'une quelconque des revendications précédentes comprenant en outre une source (31) et un drain (32) de part et d'autre du motif de grille (20), ladite source (31) traversant totalement selon la direction verticale (z) la deuxième barrière (12) à base d'AlGaN.
